# EUROPÄISCHE PATENTSCHRIFT

(11) **EP 1 404 170 B1**
(45) Veröffentlichungstag und Bekanntmachung des Hinweises auf die Patenterteilung: **24.08.2011**
(21) Anmeldenummer: 03014993.4
(22) Anmeldetag: 02.07.2003
(51) Int. Cl.: H05K 7/14, G06F 1/16

(54) **Gerätekombination**
Combination of apparatus
Combinaison d' appareil

(30) Priorität: 27.09.2002 DE 10245327; 27.09.2002 DE 10245328; 19.02.2003 DE 10306937
(43) Veröffentlichungstag der Anmeldung: 31.03.2004
(73) Patentinhaber: Eaton Industries GmbH, 53115 Bonn (DE)
(72) Erfinder: Högener, Hans-Jürgen, 53859 Niederkassel (DE); Volberg, Jürgen, 53844 Troisdorf (DE); Wiese, Artur, 53332 Bornheim (DE); Bauerfeind, Dieter, 53359 Rheinbach (DE); Schäfer, Jörg, 53359 Rheinbach (DE)

(56) Entgegenhaltungen:
- EP-A- 0 869 334
- DE-A- 19 825 584
- DE-C- 19 709 554
- US-A- 3 770 925
- US-A- 5 278 729

## Beschreibung

Die Erfindung betrifft eine modulare elektrische Gerätekombination zwischen einem ersten Modul und einem zweiten Modul, insbesondere zwischen einem Bedienmodul und einem Rechnermodul. Dabei dient das Rechnermodul der Be- und Verarbeitung sowie der Koordination von Daten und das Bedienmodul neben der Eingabe von Daten bzw. Auswahl von Befehlen und dergleichen der Anzeige von Text, Meldungen und/oder Grafiken.

Aus der Firmenschrift "Offene Kommunikation mit Standards", W27-7481 D, Moeller GmbH, 11/2000 (Bonn) sind vernetzte Lösungen für die Industrieautomation bekannt. Diese Druckschrift beschreibt bereits Kleinststeuerungen wie das Steuerrelais "easy", welches kompakt aufgebaut, eine Bedieneinheit, eine Anzeigeeinheit sowie eine integrierte Rechnereinheit aufweist. Ferner beschreibt die Druckschrift auch Kompakt-SPS und Modular-SPS (Speicherprogrammierbare Steuerungen), welche lediglich die Rechnereinheit nebst zusätzlichen Ein-/Ausgabeeinheiten (I/O's) enthalten und die über separate i.d.R. über Bussysteme vernetzte Eingabeeinheiten und Visualisierungseinheiten "bedient" werden. Diese Eingabe- und Visualisierungseinheiten sind dann beispielsweise durch externe Personal-Computer oder Operator- bzw. Touchpanels gebildet.

Diese Geräte sind für aufwendige Steuerungsaufgaben vorgesehen. Von Nachteil ist dabei, das diese Geräte entweder nicht oder nur mit entsprechendem Aufwand vor Ort, d.h. dort wo die tatsächliche Steuerung platziert ist, in die Schalttafel eines Schaltschrankes oder dergleichen montierbar sind. Insbesondere ist die Abdichtung zum Schaltschrankinneren bei einem in eine Schalttafel eingebauten Touchpanel nur sehr aufwendig realisierbar.

In der Schrift DE 44 46 167 C2 wird beispielhaft eine standardmäßige Befestigung von Befehls- und Meldegeräten in einer Schalttafel gezeigt. Die Schrift gibt keinen Hinweis auf eine modulmäßige Kombination des Befehls- und Meldegeräts mit einer weiteren Einheit.

Rastende Befestigungen eines Gehäuses in einer Bohrung einer Platte sind bekannt (siehe DE 82 32 239 U1). Ebenfalls ist bekannt, die Bedieneinheit von einer Steuereinheit trennbar auszubilden. In der DE 197 09 554 C1 wird vorgeschlagen, ein aus Oberteil und Unterteil bestehendes Gehäuse eines Geräts mit einander rastbar auszuführen. Das Oberteil kann wahlweise aus einem Bedienteil oder einem Befestigungsteil bestehen. Gemäß der DE 295 10 176 U1 ist bekannt, ein Bedienmodul über Stifte in schlüssellochartige Durchbrüche in einer Montagefläche einzuhängen. Bei dieser einfachen mechanischen Montierung kommt die elektrische Verbindung nicht zustande. Diese muss nach der örtlichen Gegebenheit getrennt vorgenommen werden.

Eine Befestigung eines Befehls- und Meldegeräts in einer Schalttafel wird in DE 198 25 584 A1 dargestellt. Das Befehls- und Meldegerät hat in seinem rückwärtigen Befestigungsabschnitt eine Ausnehmung, in die eine weitere elektrische Einheit hineinragen kann. Mittel zur unmittelbaren Kopplung des Befehls- und Meldegeräts mit der weiteren elektrischen Einheit sind in der Schrift nicht beschrieben.

Ausgehend von dem letztgenannten Stand der Technik liegt der Erfindung daher die Aufgabe zugrunde, eine in eine Montagetafel oder drgl. einbaubare Gerätekombination zu schaffen, deren Module in einfacher Weise mit mechanischen und elektrischen Verbindungsmitteln ausgestattet sind, so dass diese untereinander ummittelbar elektrisch und mechanisch koppelbar sind.

Erfindungsgemäß wird diese Aufgabe durch eine Gerätekombination gemäß den Merkmalen des Hauptanspruchs gelöst.

Der Kern der Erfindung liegt darin, dass das Bedienmodul auf seiner Gehäuse-Rückseite mindestens einen Befestigungsabschnitt zum Einbau in eine Montagetafel aufweist. Insbesondere ist der erfindungsgemäße Gegenstand für den Einbau in ein Gehäuse, in einer die Schließfunktion einer Tür steuernden Einrichtung oder in eine Schalttafel einer Leitwarte oder dergl. vorgesehenn. Zur unmittelbaren Kopplung sind bei dem Bedienmodul die mechanischen Verbindungsmittel durch den/die Befestigungsabschnitt(e) und die elektrischen Verbindungsmittel durch innerhalb des/jeden Befestigungsabschnittes angeordnete Kontaktierungsmittel ausgebildet. Das Rechnermodul weist hierfür entsprechende Gegenmittel auf.

Mit Vorteil kann die unmittelbare Kopplung der beiden Module werkzeuglos ermöglicht werden. Alternativ dazu ist aber auch eine räumlich getrennte Anordnung der Module mit einer elektrischen Verbindung über Kabel möglich (mittelbare elektrische Kopplung).

Das Bedienmodul umfasst Anzeige- und Betätigungsmittel. Als Anzeigemittel können beispielsweise ein Display und/oder Leuchtmittel (beispw. LEDs) vorhanden sein. Als Betätigungsmittel können eine Tastatur und/oder ein Sensor (beispielsweise ein Biosensor zur Erfassung von biometrischen Daten, wie Fingermuster oder drgl.) vorgesehen sein.

Den abhängigen Ansprüchen sind weitere vorteilhafte Weiterbildungen der Erfindung zu entnehmen.

So ist z.B. jeder Befestigungsabschnitt mit Vorteil in seinen Dimensionen identisch mit den Dimensionen von herkömmlichen Befehls- bzw. Meldegerätes ausgebildet. Hierdurch können für die Befehlsgeräte bereits vorhandene Werkzeuge und/oder Montagetafeln und entsprechend vorliegende Öffnungen zum Einbau des Bedienmoduls genutzt werden. Die erforderlichen Montageöffnungen in einer Montagefläche sind relativ klein, so dass eine optimierte Abdichtung des Schaltschrankinneren erfolgen kann. Die IEC-Schutzart IP 65 (vollständiger Berührungsschutz, staubdicht, dicht gegen Spritzwasser) kann hierdurch mit einfachen Mitteln gewährleistet werden.

Die Abdichtung kann noch optimiert werden, indem zusätzlich zu einer Abdichtung im Bereich des/jeden Befestigungsabschnitts bzw. im Bereich der entsprechenden Montageöffnung des/jeden Befestigungsabschnitts noch eine weitere Abdichtung zwischen Gehäuserückseite und Montagefläche durch eine zusätzliche im Randbereich des Bedienmodulgehäuses angeordnete umlaufende Dichtung oder drgl. realisiert wird.

Die elektrischen Kontaktierungsmittel sind innerhalb eines bzw. jeden Fortsatzes angeordnet; im Rechnermodul werden diese durch die im Bereich der den/jeden Fortsatz aufnehmende(n) Öffnung(en) liegende zweite Kontaktmittel (Steckkontakte) gebildet. Auf diese Weise wird eine zusätzlich gegen Feuchte und andere äußere Einflüsse geschützte Kontaktstelle geschaffen. Die Steckkontakte können durch die als Führung dienende Konstruktion der Fortsätze bei der steckenden Montage nicht durch Verbiegen beschädigt werden.

Die Befestigungselemente sind als Außengewinde auf dem Befestigungsabschnitt für einen Befestigungsring ausgebildet. Es kann jedoch auch eine Verrastung gemäß DE 198 33 093 A1 eingesetzt werden.

Die mechanischen Verbindungsmittel sind auch als Rastmittel ausgebildet, die werkzeuglos verrasten, jedoch nur unter Betätigung eines Rastschiebers entrastbar sind. Die Rastmittel sind am Bedienmodul als L-förmige Rastnase und die Rastmittel am Rechnermodul sind in einem längsverschiebbar gelagerten Rastschieber angeordnet, welche passgenau zusammenwirken.

Der Rastschieber ist mit mindestens einer Auswurfschräge ausgebildet, die bei Betätigung mit der L-förmigen Rastnase in Auswurfrichtung zusammenwirkt.

Die Rastmittel weisen zusammenwirkende Schrägflächen zur Betätigung des Rastschiebers während des Kopplungsvorgangs der beiden Module auf, insbesondere weist der bzw. einer der Befestigungsabschnitt(e) auf seiner Schmalseite eine in Betätigungsrichtung des Rastschiebers ausgerichtete Rastnase mit Einführschräge auf.

Das Rechnermodul hat auf der Seite der mechanischen Verbindungsmittel Tragschienen-Befestigungsmittel zur lösbaren Befestigung auf einer Tragschiene, wobei die Tragschiene im Bereich der mechanischen Verbindungsmittel eine Ausnehmung zum Hindurchführen der Befestigungsabschnitte aufweist.

Des Weiteren ist die Gerätekombination durch ein weiteres mechanisch und elektrisch an das Rechnermodul ankoppelbares Elektronikmodul (auch als I/O-Modul bezeichnet) zu einer eigenständigen Steuerung mit eigenen Ein- und Ausgängen erweiterbar. Hierzu hat das Rechnermodul auf seiner dem Bedienmodul abgekehrten Seite weitere eigene mechanische Verbindungsmittel und elektrische Kontaktierungsmittel. Das I/O-Modul erlaubt die Anbindung von Ein- und Ausgängen. Diese Kopplung kann ebenfalls unmittelbar über die beschriebenen Befestigungsmittel erfolgen oder im Falle räumlich beabstandeter Module lediglich über eine elektrische Kopplung per Kabel erfolgen. Durch die Kopplung aller drei Module kann eine komplette Kleinsteuerung bereitgestellt werden, mittels der Schaltfunktionen durch den Benutzer über die Bedieneinheit des Bedienmoduls eingebbar und über eine menügeführte Benutzeroberfläche auf der Anzeige des Bedienmoduls anzeigbar und programmierbar sind. Hierbei kann vorzugsweise die die Kleinsteuerung bildende Elektronik unter Kontrolle eines im Rechnermodul hinterlegten Programms den Stromfluss zwischen den Eingängen und den Ausgängen des I/O-Moduls schalten.

Weitere Einzelheiten und Vorteile der Erfindung ergeben sich aus den folgenden, anhand von Figuren erläuterten Ausführungsbeispielen. Es zeigen
- Figur 1A:: eine perspektivische Darstellung einer Ausführung mit Bedienmodul, Rechnermodul, I/O-Modul und angekoppeltem Erweiterungsmodul auf Tragschiene montiert;
- Figur 1 B:: wie Figur 1A, jedoch mit Bedienmodul als Fingerscanner,
- Figur 2a:: das Bedienmodul in perspektivischer Ansicht seiner Rückseite;
- Figur 2b:: das Bedienmodul in Seitenansicht;
- Figur 3a:: das Rechnermodul in perspektivischer Ansicht;
- Figur 3b:: einen Rastschieber mit Feder,
- Figur 4:: Rechnermodul und I/O-Modul in Explosionsdarstellung (Rückansicht) und
- Figur 5:: Rechnermodul und I/O-Modul in Explosionsdarstellung (Vorderansicht).

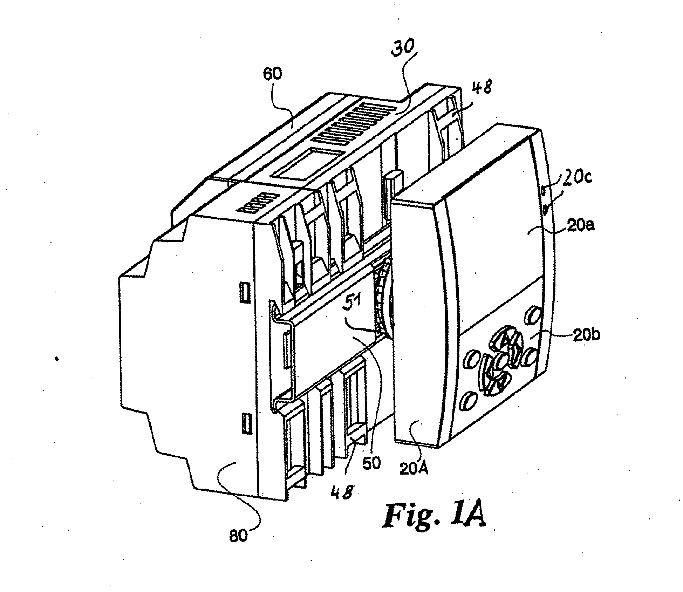

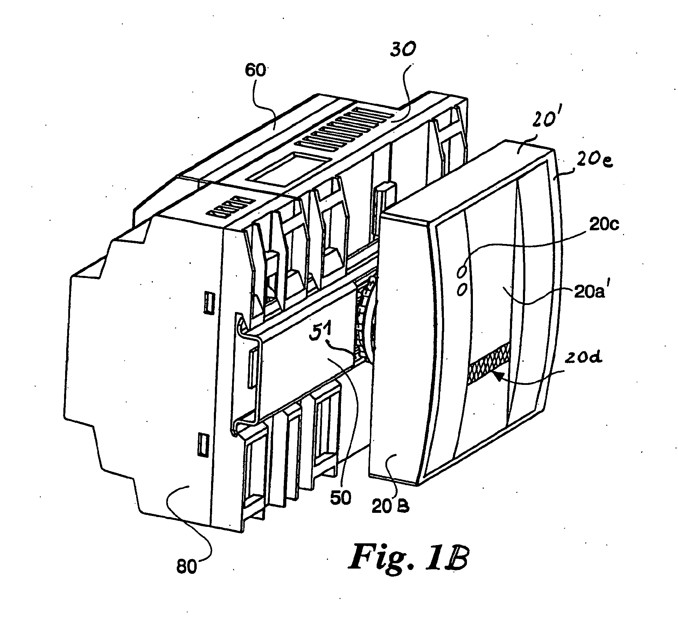

Figur 1A und 1B zeigen je eine erfindungsgemäße modulare Gerätekombination mit insgesamt vier verschiedenen Modulen (20A bzw. 20B,30,60,80), die miteinander unmittelbar mechanisch und elektrisch zu einer Einheit verbunden sind. Dabei ist die Einheit über einzelne Module auf einer Hutschiene (50) befestigt.

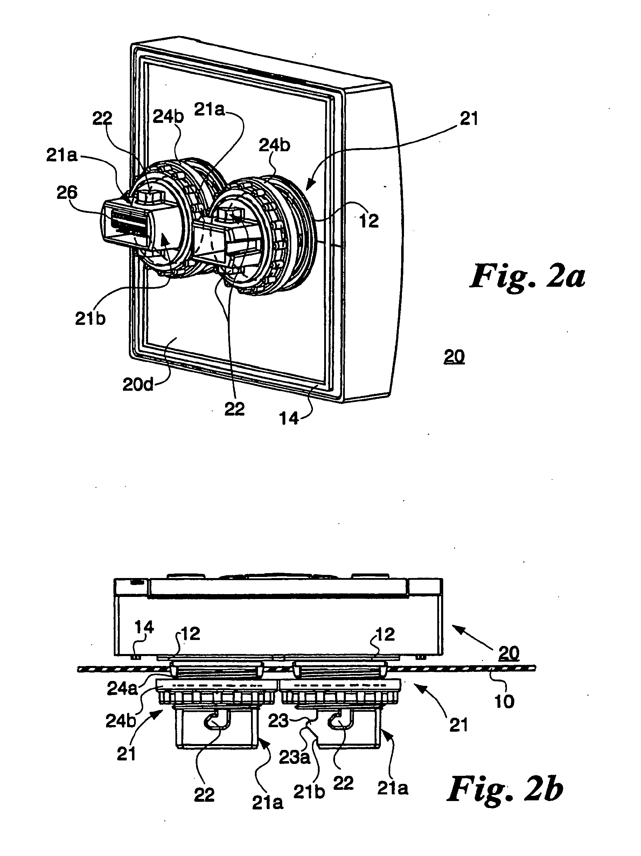

Die Gerätekombination umfasst ein Bedienmodul (20A,20B) und ein mit diesem unmittelbar elektrisch und mechanisch koppelbares, im folgenden Rechnermodul 30 genanntes Modul. Erfindungsgemäß weist das Bedienmodul (20A,20B) auf seiner Rückseite 20d mindestens einen - vorzugsweise genau zwei - Befestigungsabschnitt(e) 21 (Fig. 2a, Fig. 2b) zum Einbau beziehungsweise zur Befestigung an/in einer Montagetafel 10 auf. Insbesondere ist die Gerätekombination für den Einbau in eine Schaltschranktür, die Schalttafel einer Leitwarte oder in ein separates Zusatzgehäuse für den rauhen Einsatz in Industrieanlagen vorgesehen. Erfindungsgemäß umfasst das Bedienmodul 20 Anzeige- und Betätigungsmittel. Als Anzeigemittel ist in Fig. 1A ein integriertes grafikfähiges Display 20a dargestellt. Als Betätigungsmittel ist eine integrierte Tastatur 20b zur Bedienung bzw. zur Eingabe von Daten oder Befehlen oder dergleichen - insbesondere ist eine geringe Anzahl von Tasten (etwa nicht mehr als 10) vorgesehen.

In Fig. 1B ist als Bedienmodul ein Fingerscanner 20B zu erkennen. Letzterer umfasst ein insbesondere zweiteiliges Gehäuse (20') mit einem topfartigen, umlaufenden Gehäusedeckel 20e. Die Frontfläche des Fingerscanners zeigt eine ebene Gleitfläche 20a', über die ein Benutzer einen Finger entlang gleiten lassen kann. Das Papillarmuster seiner Fingerkuppe wird vom schlitzartig ausgebildeten Sensor 20d erfasst und an das Rechnermodul 30 weitergegeben. Weiterhin sind auf der Frontfläche zwei Leuchtdioden 20c erkennbar, mit denen durch Farb- und/oder Blinksignale der Betriebszustand des Fingerscanners angebbar ist.

Jeder Befestigungsabschnitt 21 ist vorzugsweise als in der Form eines standardmäßigen Gehäuseteils, wie er bei Befehls- und/oder Meldegeräten Verwendung findet, ausgebildet. Solche Befestigungsabschnitte sind in der Regel zylindrisch mit kreisrundem Querschnitt (16, 18, 20 oder 22 mm ⌀) und mit entsprechendem Außengewinde ausgebildet. Das hat den Vorteil, dass die Gerätekombination in bereits vorhandene Standardöffnungen eingesetzt oder mit bereits vorhandenen Werkzeugen für die Montage von Befehls- und Meldegeräten verwendeten Werkzeugen montiert werden kann. In einer bevorzugten Ausführung ist ein derartiger Befestigungsabschnitt 21 einteilig mit der Rückwand 20d des Gehäuses 20' des Bedienmoduls (20A, 20B) ausgebildet. Auf einfache Weise können Rückwand und Befestigungsabschnitt(e) als Kunststoff-Formspritzteil ausgeführt sein. In das Spritzteil können im Zwei-Komponenten-Spritzgießverfahren ein oder mehrere Dichtelemente (mit geringer Stookes-Härte) eingebracht sein. Solche Dichtelemente sind mit Bezugszeichen 12 und 14 dargestellt. Das Dichtelement 12 ist als Dichtungsring ausgebildet, der am Fuß jeden Befestigungsabschnitts in einer nutartigen Vertiefung in der Rückwand 20d des Bedienmodulgehäuses 20' liegt. Der Dichtungsring ist eine weichelastische Masse (mit geringer Stookes-Härte), die - wie erwähnt - im Zweikomponenten-Spritzgußverfahren schon bei der Herstellung der Rückwand eingebracht ist.

Zur Koppelung eines der Bedienmodule 20A oder 20B mit dem Rechnermodul 30 sind die mechanischen Verbindungsmittel 21a;22 derart ausgebildet, dass die Kopplung werkzeuglos erfolgen kann. Hierfür weist jeder Befestigungsabschnitt 21 an seinem freien Ende einen sich anschließenden Fortsatz 21a mit im wesentlichen rechteckigen Querschnitt auf. Dabei sind im Innern des Befestigungsabschnittes 21, vorzugsweise nur in der Tiefe des Fortsatzes 21a elektrische Kontaktierungsmittel 26 in Form eines mehrpoligen Steckers oder drgl. angeordnet. Zur Aufnahme des Fortsatzes 21a ist im Gehäuseboden 40' des Rechnermoduls 30 eine an die Geometrie des Fortsatzes 21a angepasste Ausnehmung 41 in Art eines Rahmens vorgesehen. so dass eine passgenaue Einführung des Fortsatzes 21a in die Ausnehmung 41 im Boden des Rechnermoduls stattfindet. Um eine eindeutige Lagezuordnung zu erreichen (zur Verhinderung des Einschiebens in verdrehter Stellung), ist an einem der Fortsätze 21 a eine Nut 21c und am Rahmen der Ausnehmung eine Nase 41c vorhanden.

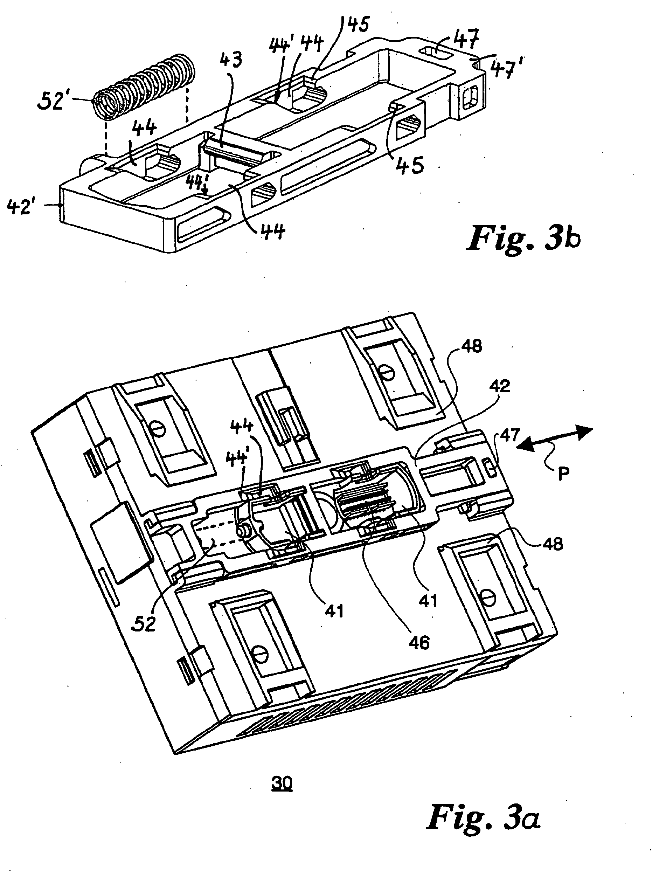

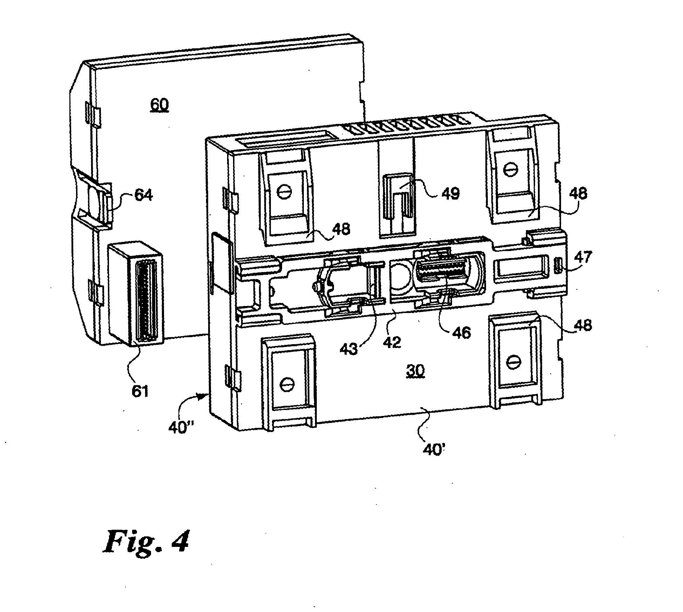

Da das Rechnermodul mit weiteren Modulen bestückbar ist, und weil sich dadurch das Gewicht erhöht, sind weitere Verrastungselemente vorgesehen, die in einem Rastschieber 42 angeordnet sind. Die Figuren 3a und 4 zeigen den Rastschieber 42. In Fig. 3b ist in geometrisch etwas abgewandelter Form ein Rastschieber 42' vergrößert dargestellt. Der Rastschieber (42, 42') ist längsbeweglich auf dem Gehäuseboden 40' des Rechnermoduls 30 federbeweglich (Feder 52 oder 51') gelagert. Vorzugsweise ist die Lagerung derart, dass der Rastschieber leicht entnehmbar ist. Dies kann sinnvoll sein, wenn das Rechnermodul auf einer Tragschiene aufgeclipst werden soll, die sich auf der Montagewand befindet. Das Aufclipsen auf die Hutschiene wäre schwierig, wenn nicht unmöglich, wenn der Rastschieber vorhanden ist. Das Rechnermodul kann dann nicht in die passende Winkellage zum Aufclipsen gebracht werden.

Beim Einführen des Bedienmoduls in die Ausnehmungen 41 wird der Rastschieber über eine Offen-Position in eine Rast-Position bewegt. Hierzu hat zumindest ein Befestigungsabschnitt 21 auf der Schmalseite seines Fortsatzes 21a eine in Betätigungsrichtung P des Rastschiebers 42 ausgerichtete Rastnase 23, die eine Einführschräge 23a aufweist. Rastnase 23 und Einführschräge 23a wirken mit einer entsprechenden Wulst 43 quer zur Richtung P im Rastschieber 42;42' zusammen.

In der tiefsten Stellung des Bedienmoduls in den Ausnehmungen 41 bewegt sich der Rastschieber in die Rast-Position. Die Entnahme eines der Module 20A oder 20B ist nicht mehr durch einfaches Herausziehen möglich. In dieser Position wirken Rastnasen 22 am Fortsatz 21a mit Nocken 45 am Rastschieber zusammen. Gemäß Ausführungsbeispiel hat der Fortsatz 21a zumindest auf einer seiner eben ausgebildeten Längsflächen diese L-förmigen Rastnasen 22.

Zur Entnahme eines Bedienmoduls muss eine Entriegelung vorgenommen werden. Hierzu muss der Rastschieber per Hand oder mit einem Werkzeug bewegt werden. Der Rastschieber 42 weist daher eine Griffkante 47' oder einen Eingriff 47 zur Aufnahme eines stiftartigen Werkzeugs (beispw. für einen Schraubendreher) auf. Bei der Bewegung des Rastschiebers wird das Bedienmodul ausgeworfen. Zu diesem Zweck sind die Rastnasen 22 und hiermit korrespondierende Rastausnehmungen 44 des Rastschiebers 42;42' mit Ausführschrägen 44' versehen.

In der Darstellung der Figuren 1A und 1B ist auf dem Gehäuseboden 40' des Rechnermoduls 30 eine Tragschiene 50 mit einem Fenster 51 zu erkennen. Die Tragschiene dient zur Aufnahme weiterer Module (80). Zum Anklemmen der Tragschiene dienen die Befestigungselemente 48 und 49. Die Hutschiene 50 hat für die Kopplung von Bedienmodul 20 mit Rechnermodul 30 für das Hindurchführen der Fortsätze 21a ein Fenster 51. Ein weiteres Fenster kann ggf. (daher nicht gezeigt) vorgesehen sein zum separaten Hindurchführen noch weiterer elektrischer Kontaktierungsmittel. Hier ist kein separates Fenster erforderlich, da die Kontaktierungsmittel im Befestigungsabschnitt angeordnet sind.

Weitere Module 80 sind seitlich vom Rechnermodul 30 montierbar und dort an dieses elektrisch und mechanisch ankoppelbar. Beispielsweise kann über ein solches Erweiterungsmodul 80 die Kopplung an ein bestimmtes Bussystem wie AS-i, Profibus oder dergl. oder an eine Erweiterungseinheit mit zusätzlichen Ein- und Ausgangsanschlüssen erfolgen.

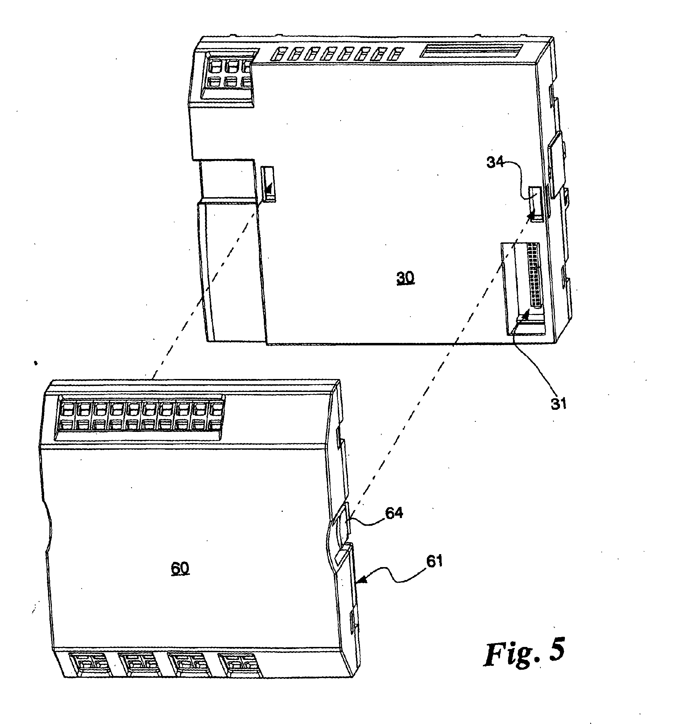

Die Gerätekombination ist durch ein elektrisch oder elektrisch und mechanisch ankoppelbares Elektronikmodul 60 (beispielsweise ein I/O-Modul) erweiterbar. Rechnermodul und I/O-Modul 60 sind in Fig. 4 und 5 in verschiedenen Ansichten sichtbar. Das I/O-Modul 60 kann als eine, in einem weiteren separaten Gehäuse angeordnete Elektronik ('Steuerung') zur Umsetzung und Weiterleitung von Eingangs- und/oder Ausgangssignalen ausgebildet sein, wobei beispielsweise auch der Stromfluss zwischen den Eingängen und den Ausgängen in einem weiteren Elektronikmodul geschaltet werden kann.

Für den Anschluss von Eingangs- und Ausgangsleitungen sind Anschlussmittel in Form von Schraub- oder Federklemmanschlüssen oder dergleichen vorhanden. Die elektrische Kontaktierung zwischen I/O-Modul 60 und Rechnermodul 30 erfolgt vorzugsweise über eine 36-polige Steckerverbindung 31; 61. Dabei ist das Steckerteil 31 des Rechnermoduls 30 vorzugsweise in einer Gehäuseöffnung innenliegend angeordnet, während das Steckerteil 61 des I/O-Moduls 60 in einem eine Führung bildenden, im Querschnitt rechteckigen Steckerfortsatz angeordnet ist. Auf diese Weise ist eine stets sichere Kontaktierung gewährleistet, deren Zuverlässigkeit auch nach mehrfacher Montage und Demontage zuverlässig arbeitet. Zur mechanischen Verbindung weist das I/O-Modul 60 an zwei gegenüberliegenden Seitenwände elastische Rasthaken 64 zum Eingriff in Rastausnehmungen 34 der Gehäuseoberfläche des Rechnermoduls 30 auf. Auf diese Weise ist eine sichere unmittelbare (d.h. ohne Zwischenschaltung einer zusätzlichen Verbindungsleitung) elektrische Kontaktierung realisierbar.

## Patentansprüche

1. Modulare elektrische Gerätekombination zwischen einem ersten Bedienmodul (20A, 20B) und einem Rechnermodul (30), wobei das erste Modul (20A, 20B) in einem Gehäuse (20') untergebracht und mit Anzeigemittel (20a; 20c) und/ oder mit Betätigungsmittel (20b) versehen ist und auf seiner Rückseite mindestens einen Befestigungsabschnitt (21) zum Durchgriff durch eine entsprechende Montageöffnung einer Montagetafel (10) aufweist, wobei mindestens ein Befestigungsabschnitt (21) Befestigungselemente (24a;24b) zur Befestigung an der Montagetafel (10) umfaßt, und wobei beide Module (20; 30) weiterhin jeweils mit elektrischen (26) und mechanischen (23,42,43) Mitteln zur trennbaren Verbindung untereinander ausgestattet sind,
**dadurch gekennzeichnet, dass** die mechanischen (23; 42;43) Verbindungsmittel derart ausgebildet sind, daß die kopplung werkzeuglos erfolgen kann, und daβ der die elektrischen Verbindungsmittel (26;23,42,43) umfassende Befestigungsabschnitt (21) an seinem freien Ende einen Fortsatz (21a) aufweist, innerhalb dessen die elektrischen Verbindungsmittel (26;23,42,43) untergebracht sind.

2. Gerätekombination nach Anspruch 1, **dadurch gekennzeichnet, dass** auf der Rückseite des Gehäuses (20') des Bedienmoduls (20A, 20B) im Bereich der Befestigungsabschnitte (21) mindestens ein Element (12,14) für spritzwassergeschütztes Abdichten zwischen Gehäuse (20') und Montagetafel (10) angeordnet ist.

3. Gerätekombination nach einem der vorstehenden Ansprüche, **dadurch gekennzeichnet, dass** die Befestigungselemente (24a;24b) zur Befestigung an der Montagetafel (10) als Gewinde (24a) für einen Befestigungsring (24b) ausgebildet sind.

4. Gerätekombination nach einem der vorstehenden Ansprüche, **dadurch gekennzeichnet, dass** die mechanischen Verbindungsmittel als Rastmittel (22;45) ausgebildet sind, die werkzeuglos verrasten, jedoch nur unter Betätigung eines Rastschiebers (42, 42') entrastbar sind.

5. Gerätekombination nach Anspruch 4, **dadurch gekennzeichnet, dass** die Rastmittel am Bedienmodul als L-förmige Rastnase (22) und Rastmittel (45) am Rechnermodul in einem längsverschiebbar gelagerten Rastschieber (42, 42') angeordnet sind, welche passgenau zusammenwirken.

6. Gerätekombination nach Anspruch 5, **dadurch gekennzeichnet, dass** der Rastschieber (42,42') mit mindestens einer Auswurfschräge (44') ausgebildet ist, die bei Betätigung mit einer L-förmigen Rastnase (23) in Auswurfrichtung zusammenwirkt.

7. Gerätekombination nach einem der Ansprüche 4 bis 6, **dadurch gekennzeichnet, dass** der Rastschieber (42) zum Zwecke seiner Betätigung einen Eingriff (47) zur Aufnahme eines stiftartigen Werkzeugs aufweist.

8. Gerätekombination nach einem der Ansprüche 4 bis7, **dadurch gekennzeichnet, dass** der Rastschieber (42) Rastmitteln des Fortsatzes (21 a) zusammenwirkende abfallende Auswurfschrägen (44') aufweist, die bei Betätigung (P) des Rastschiebers (42) das Rechnermodul vom Bedienmodul trennen.

9. Gerätekombination nach einem der vorhergehenden Ansprüche, **dadurch gekennzeichnet, dass** die Anzeigemittel als ein Display (20a) und/oder als LED-Anzeigen (20c) und die Dateneingabemittel als Tasten einer Tastatur (20b) und/oder als Sensor, insbesondere als Biometriesensor ausgebildet sind.

10. Gerätekombination nach einem der vorhergehenden Ansprüche, **dadurch gekennzeichnet, dass** das Rechnermodul (30) auf der Seite (40') der mechanischen Verbindungsmittel Tragschienen-Befestigungsmittel (48) zur lösbaren Befestigung auf einer Tragschiene (50) aufweist, wobei die Tragschiene (50) im Bereich der mechanischen Verbindungsmittel (41, 42) eine Ausnehmung (51) zum Hindurchführen der Befestigungsabschnitte (21) aufweist.

11. Gerätekombination nach einem der vorhergehenden Ansprüche, **dadurch gekennzeichnet, dass** das Rechnermodul (30) auf seiner dem Bedienmodul (20A, 20B) abgekehrten Seite (40") weitere mechanische Verbindungsmittel (42) und elektrische Kontaktierungsmittel (41) zur mechanischen und elektrischen Kopplung mit einem weiteren Elektronikmodul (60) aufweist.

12. Gerätekombination nach Anspruch 11, **dadurch gekennzeichnet, dass** das Rechnermodul (30) Teil einer Steuerelektronik ist, wobei Schalt- oder Steuerfunktionen durch einen Benutzer über die Dateneingabemittel (20b) eingebbar und programmierbar und auf dem Anzeigemittel (20a), insbesondere auf einem Display (20) als menügeführte Benutzeroberfläche anzeigbar sind.

## Claims

1. Modular electrical device combination between a first operating module (20A, 20B) and a computer module (30), the first module (20A, 20B) being accommodated in a housing (20') and being provided with display means (20a; 20c) and/or with actuation means (20b) and comprising on the rear face thereof at least one fixing portion (21) for engaging through a corresponding mounting opening in a mounting panel (10), at least one fixing portion (21) comprising fixing members (24a; 24b) for fixing to the mounting panel (10), and the two modules (20; 30) each further being equipped with electrical (26) and mechanical (22, 42, 43) means for separable connection to one another,
**characterised in that** the mechanical (23; 42; 43) connection means are configured in such a way that the coupling can take place without tools, and **in that** the fixing portion (21) comprising the electrical connection means (26; 23, 42, 43) has at the free end thereof an extension (21a) inside which the electrical connection means (26; 23, 42, 43) are accommodated.

2. Device combination according to claim 1, **characterised in that** at least one member (12, 14) for splash-proof sealing between the housing (20') and the mounting panel (10) is arranged on the rear face of the housing (20') of the operating module (20A, 20B) in the region of the fixing portions (21).

3. Device combination according to any one of the preceding claims, **characterised in that** the fixing members (24a; 24b) are formed for fixing to the mounting panel (10) as a thread (24a) for a fixing ring (24b).

4. Device combination according to any one of the preceding claims, **characterised in that** the mechanical connection means are formed as locking means (22; 45) which lock without tools but can only be unlocked by actuating a locking bolt (42, 42').

5. Device combination according to claim 4, **characterised in that** the locking means are arranged on the operating module as an L-shaped locking tab (22) and locking means (45) are arranged on the computer module in a longitudinally displaceably mounted locking bolt (42, 42'), and these cooperate with an exact fit.

6. Device combination according to claim 5, **characterised in that** the locking bolt (42, 42') is formed with at least one ejection slope (44') which, when actuated, cooperates with an L-shaped locking tab (23) in the ejection direction.

7. Device combination according to any one of claims 4 to 6, **characterised in that** the locking bolt (42) comprises for the actuation thereof an engagement (47) for receiving a pin-like tool.

8. Device combination according to any one of claims 4 to 7, **characterised in that** the locking bolt (42) comprises descending ejection slopes (44') which cooperate with locking means of the extension (21a) and which separate the computer module from the operating module when the locking bolt (42) is actuated (P).

9. Device combination according to any one of the preceding claims, **characterised in that** the display means are formed as a display (20a) and/or as LED displays (20c) and the data input means are formed as keys on a keyboard (20b) and/or as a sensor, in particular as a biometric sensor.

10. Device combination according to any one of the preceding claims, **characterised in that** the computer module (30) comprises, on the same face (40') as the mechanical connection means, carrier rail fixing means (48) for detachable fixing to a carrier rail (50), the carrier rail (50) comprising, in the region of the mechanical connection means (41, 42), a clearance (51) for the fixing portions (21) to pass through.

11. Device combination according to any one of the preceding claims, **characterised in that** the computer module (30) comprises, on the face (40") thereof remote from the operating module (20A, 20B), further mechanical connection means (42) and electrical contacting means (41) for mechanical and electrical coupling to a further electronic module (60).

12. Device combination according to claim 11, **characterised in that** the computer module (30) is part of an electronic control system, it being possible for a user to input and program switching or control functions via the data input means (20b) and for these functions to be displayed on the display means (20a), in particular on a display (20) as a menu-driven user interface.

## Revendications

1. Combinaison d'appareil électrique modulaire entre un premier module de commande (20A, 20B) et un module d'ordinateur (30), le premier module (20A, 20B) étant logé dans un boîtier (20') et comportant des moyens d'affichage (20a ; 20c) et/ou des moyens d'actionnement (20b), et comportant sur son côté arrière au moins une section de fixation (21) en vue du passage à travers une ouverture de montage correspondante dans un tableau de montage (10), au moins une section de fixation (21) englobant des éléments de fixation (24a ; 24b) pour la fixation sur le tableau de montage (10), les deux modules (20 ; 30) comportant en outre des moyens électriques (26) et mécaniques (23, 42, 43) pour assurer un assemblage mutuel séparable ;
**caractérisée en ce que** les éléments d'assemblage mécaniques (23 ; 42 ; 43) sont configurés de sorte que l'accouplement peut être effectué sans outil et **en ce que** la section de fixation (21), englobant les moyens d'assemblage électriques (26 ; 23 ; 42, 43), comporte au niveau de son extrémité libre une extension (21a) dans laquelle sont logés les moyens d'assemblage électriques (26 ; 23, 42, 43).

2. Combinaison d'appareil selon la revendication 1, **caractérisée en ce que** le côté arrière du boîtier (20') du module de commande (20A, 20B) comporte, dans la région des sections de fixation (21), au moins un élément (12, 14) pour établir une étanchéité à protection contre les projections d'eau entre le boîtier (20') et le tableau de montage (10).

3. Combinaison d'appareil selon l'une des revendications précédentes, **caractérisée en ce que** les éléments de fixation (24a, 24b) destinés à assurer la fixation sur le tableau de montage (10) ont la forme de filets (24a) pour une bague de fixation (24b).

4. Combinaison d'appareil selon l'une des revendications précédentes, **caractérisée en ce que** les moyens d'assemblage ont la forme de moyens de verrouillage (22 ; 45), permettant un verrouillage sans outil, mais ne pouvant être déverrouillés que par l'intermédiaire d'un curseur de verrouillage (42, 42').

5. Combinaison d'appareil selon la revendication 4, **caractérisée en ce que** les moyens de verrouillage sont agencés sur le module de commande sous forme d'un ergot de verrouillage en forme de L (22), et des moyens de verrouillage (45) agencés sur le module d'ordinateur dans un curseur de verrouillage à déplacement longitudinal (42, 42'), avec une coopération à ajustement précis.

6. Combinaison d'appareil selon la revendication 5, **caractérisée en ce que** le curseur de verrouillage (42, 42') comporte au moins un chanfrein d'éjection (44'), coopérant en cas de son actionnement avec un ergot de verrouillage en forme de L (23) dans la direction de l'éjection.

7. Combinaison d'appareil selon l'une des revendications 4 à 6, **caractérisée en ce que** le curseur de verrouillage (42) comporte en vue de son actionnement un espace d'engagement (47) pour recevoir un outil en forme de goupille.

8. Combinaison d'appareil selon l'une des revendications 4 à 7, **caractérisée en ce que** le curseur de verrouillage (42) comporte des chanfreins d'éjection (44') coopérant avec les moyens de verrouillage de l'extension (21a), séparant, lors de l'actionnement (P) du curseur de verrouillage (42), le module d'ordinateur du module de commande.

9. Combinaison d'appareil selon l'une des revendications précédentes, **caractérisée en ce que** les moyens d'affichage ont la forme d'un écran d'affichage (20a) et/ou d'écrans d'affichage à DEL (20c), les moyens d'entrée des données ayant la forme de touches d'un clavier (20b) et/ou d'un capteur, en particulier d'un capteur biométrique.

10. Combinaison d'appareil selon l'une des revendications précédentes, **caractérisée en ce que** le module d'ordinateur (30) comporte sur le côté (40') des moyens d'assemblage mécaniques des moyens de fixation sur des rails de support (48), en vue d'une fixation amovible sur un rail de support (50), le rail de support (50) comportant dans la région des moyens d'assemblage mécaniques (41, 42) un évidement (51), permettant le passage des sections de fixation (21).

11. Combinaison d'appareil selon l'une des revendications précédentes, **caractérisée en ce que** le module d'ordinateur (30) comportent sur son côté opposé (40") au module de commande (20A, 20B), des moyens d'assemblage mécaniques additionnels (42) et des moyens de contact électriques (41), en vue de l'accouplement mécanique et électrique avec un module électronique additionnel (60).

12. Combinaison d'appareil selon la revendication 11, **caractérisée en ce que** le module d'ordinateur (30) fait partie d'une électronique de commande, les fonctions de commutation ou de commande pouvant être entrées et programmées par un utilisateur par l'intermédiaire des moyens d'entrée des données (20b) et pouvant être affichées sur le moyen d'affichage (20a), en particulier sur un écran d'affichage (20) sous forme d'une surface utilisateur pilotée par le menu.
